# EUROPEAN PATENT APPLICATION

(11) **EP 0 849 880 A1**
(43) Date of publication of application: **24.06.1998**
(21) Application number: 97500163.7
(22) Date of filing: 01.10.1997
(51) Int. Cl.: H03K 5/00

(54) **Integrated frequency multiplier circuit**

(30) Priority: 16.12.1996 ES 9602653
(71) Applicant: TELEFONICA DE ESPANA, S.A., 28013 Madrid (ES)
(72) Inventor: Conesa Lareo, José Luis, 28020 Madrid (ES)
(74) Representative: Sanchez del Campo Gonzalez de Ubierna, Ramon

(57) **Abstract**

Integrated frequency multiplier circuit, consisting of four blocks: a frequency multiplier (1), an initialization signal generator (2), a data sampling generator (3), and a clock generator (4), the frequency multiplier block (1) being formed by a time metering module (17), a time calculator (18), and an output signal generator (19), generating two initialization signals (12) and (13), one complementary to other, with a timing higher than 20 msec.

## Description

### BACKGROUND OF THE INVENTION

The present specification refers to an application for a patent of invention related to an Integrated Frequency Multiplier Circuit, the specific application of which is to generate a binary frequency signal which is a multiple of other input signal.

### FIELD OF THE INVENTION

This invention will find application in the field of telecommunications, specifically in digital systems.

### RELATED ART

The applicant, on his side, knows that in many systems it is necessary to have clock signals of different frequencies in order to time the functions of the integrated circuit composing it.

The obtaining of clocks derived from others is easy whether they can be obtained on the basis of dividing the clock of reference by an integer.

Sometime, it is necessary to obtain a frequency clock signal multiple of that of a starting signal, this problem being substantially more complex.

The applicant, on his part, knows the existence in the market of commercial products of high accuracy having this functional character, but of lesser size and cost than the Integrated Frequency Multiplier Circuit of the invention, configured as a most economic solution and having a smaller size, for those applications wherein it is not necessary a great accuracy, and including in its architecture, among other blocks, a frequency multiplier block generating a frequency clock signal which is a multiple of that of a reference signal.

### SUMMARY OF THE INVENTION

The Integrated Frequency Multiplier Circuit as proposed by this invention constitute, per se, aneconomic solution and a smaller size for those applications wherein a great accuracy is not necessary,and it includes in its context, among other blocks, a frequency multiplier block generating a frequency clock signal which is a multiple of that a reference signal.

In a most definite way, the Integrated Frequency Multiplier Circuit of the invention is, basically constituted by the following blocks, namely:
1.- A frequency multiplier.
2.- An initialization signal generator.
3.- A data sampling generator.
4.- A clock generator.

The operation of each of the blocks is independent of the rest.

The frequency multiplier block generating a digital frequency signal which is a multiple of that of therecurrent reference digital signal entering, is constituted by the following modules, namely:
- Time measuring module.
- Time computing module.
- Output signal generator module.

The time measuring module is a counter which, through a clock signal, of a frequency larger enough than that of the reference signal, measures the time elapsed between changes of state of the reference signal.

This time, along with the number of times it is desired the frequency of the output signal with regard to that of reference to be multiplied, serves as data for the time computing module to compute the time in which a change of state at the output signal is to be produced.

This datum is signalized to the output signal generator module, which will cause a change of state at the output signal, each time said time elapses.

The initialization signal generator block generates two signals: one complementary to the other, which are activated when the initialization signal of the Integrated frequency multiplier circuit is activated.

These signals, generated by the initialization signal generator block, allow the activation of several circuits composing a system in an adequate order, to be performed.

The deactivation of both signals is performed after a definite period of time, from the deactivation of the initialization signal of the integrated frequency multiplier circuit.

The data sampling signal generator block is an AND gate generating an output signal obtained as an AND logical function between two input signals.

The clock generator block is fitted with the necessary logic for generating two frequency clock signals, submultiple of that an input clock signal serving it as a reference, one of them being qualified by an input-signal to the block so that if it is high, it disqualifies its generation.

The initialization of the generation of the two clock signals is performed after deactivating the initialization signal of the integrated frequency multiplier circuit.

### BRIEF DESCRIPTION OF THE DRAWINGS

In order to complement this description and to aid to a better understanding of the characteristics of the invention, the appending sheet.of drawings, which is apart of this specification, shows, by way of illustrative and non-limiting exemple the following:-

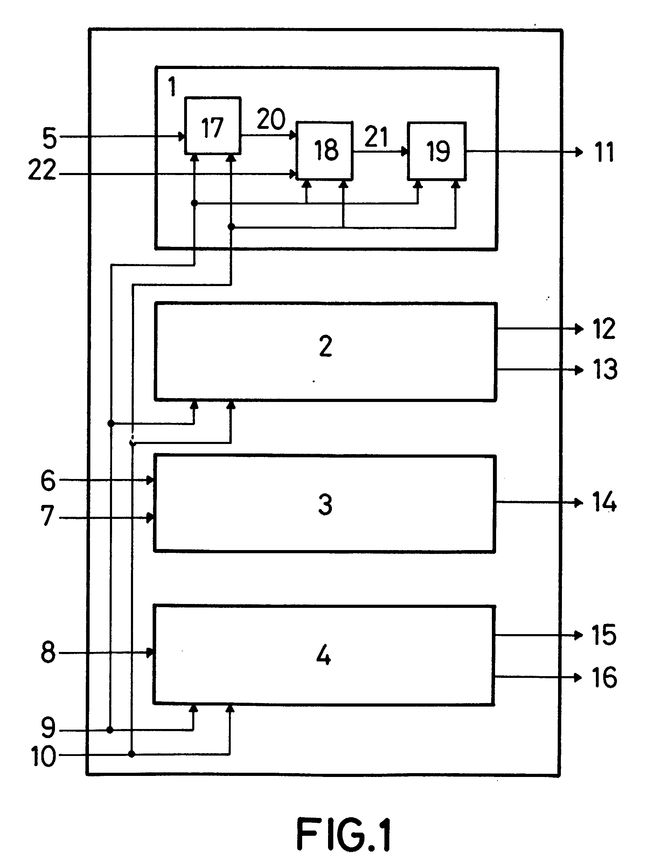

Figure 1 and unique shows a block diagram corresponding to the Integrated Frequency Multiplier Circuit of the invention, the signals and blocks of same being indicated by means of numerical references.

### DETAILED DESCRIPTION OF THE PREFERRED EMBODIMENT.

From the Fig. 1 and unique, it can be seen that the integrated frequency multiplier circuit of the invention is constituted by the following blocks, namely:-
- A frequency multiplier (1).
- An initialization signal generator (2).
- A data sampling signal generator (3).
- A clock generator (4).

The operation of each of the above-mentioned blocks is independent of the rest.

The frequency multiplier block (1) generating a digital signal (11) of frequency, multiple to that of the recurrent digital signal of reference (5) entering, is constituted by the following moduled:
- Time measuring module (17).
- Time computing module (18).
- Output signal generator module (19).

The time measuring module (17) is a counter which, by means of a clock signal (10), of a frequency larger enough than that of the signal of reference (5), measures the time elapsed between state changes of the reference signal.

This time, along with the number of times it is desired the frequency of the output signal, with regard to that of reference, to be multiplied, serves as data through the signals (20) and (22), for the time computing module (18) to compute the time in which a change of state at the output signal is to be produced.

This datum is signalized, through the signal (21), to the output signal generator module (19), which will cause a change of state at the output signal (11),-each time said time elapses.

For a correct functional caracter of this block, it is necessary that the signal of reference (5), in addition to be a recurrent one, has a working cycle (related between the time the signal is at a high level, and that it is at a lower level) next to 50 percent.

Any variation of these factors will impair the working cycle of the output signal (11).

The initialization of the generation of the output signal (11), is performed after the deactivation of the initialization signal (9) of the integrated frequency multiplier circuit of this invention.

The initialization signal generator block (2) is in charge of generating the two initialization signals (12) and (13), one complementary to the other, with a timing which is superior to 20 mseg.

The generation of these signals is activated when the initialization signal (9) of the integrated frequency multiplier circuit is activated, and it stops once a timing superior to 20 msec is attained.

The signals (12) and (13) allow the activation of different circuit composing a system in an adequate order to be performed.

The data sampling generator block (3) is an AND gate generating an output signal (14), obtained as a logical function AND between two input signals (6) and (7).

The clock generator block (4) consists of the necessary logic for generating two clock signals (15) and (15), starting from the signal of reference (10).

The frequency of signal (15) will be a half that of the reference (10); that of signal (16) will be that of the reference signal (10) divided by 32.

The generation of signal (16) is qualified by an input signal to block (8), so that if it is at a high level, it disqualifies its generation.

The initialization of the generation of the two clock signals (15) and (16) is performed after deactivating the initialization signal (9) of the integrated frequency multiplier circuit.

It is not considered necessary to extend this description for any expert in the art to understand the scope of the invention, and the advantages derived from it

The materials, shape, size and arrangement of the components will be open to variation, provided that it does not imply any alteration to the essence of the invention.

The terms under which this specification has been described should be always taken in an ample and non-limitative sense.

## Claims

1. An Integrated Frequency Multiplier Circuit, of those constituted by a frequency multiplier block (1), an initialization signal generator (2), a data sampling signal generator (3), and a clock generator (4), characterized in that the frequency multiplier block (1), through a signal (10) of a larger frequency than that of recurrent reference signal (5), both input signals to module (17) obtaining the time elapsed between changes of state of the signal of reference (5), generates, through a module (19), a frequency output signal which is a multi-ple of the mentioned reference signal (5), upon utilizing the time obtained by the module (17) as an input datum (20) to module (18), along with the signal indicative of the number of times it is desired to multiply the frequency of the reference signal (5), said module (18) computing the time in which a change of state is to be produced in the output signal (11).

2. An Integrated Frequency Multiplier Circuit,according to claim 1, characterized in that the blocks configuring the circuit are integrated in same, the initialization (9) and the input reference clock (10) being common in the different blocks.

3. An Integrated Frequency Multiplier Circuit, - according to any of the preceding claims, characterized in that the initialization signal generator block (2) generates an initialization signal (12) the deactivation of which is produced with some delay after the deactivation of the initialization signal (9) of the Integrated Frequency Multiplier Circuit.

4. An Integrated Frequency Multiplier Circuit, - according to claim 1 and 2, characterized in that the clock generator block (4) generates two clock signals (15) and (16) of frequencies which are submultiples of that of input clock signal (10),one of them being qualified through an external signal (8).
